# EUROPEAN PATENT APPLICATION

(11) **EP 2 940 077 A1**
(43) Date of publication of application: **04.11.2015**
(21) Application number: 13868425.3
(22) Date of filing: 25.12.2013
(51) Int. Cl.: C08L 83/07, C08G 77/38, C08K 3/22, C08L 83/05, C08L 83/14, C09J 11/04, C09J 183/05, C09J 183/06, C09J 183/07

(54) **CURABLE POLYORGANOSILOXANE COMPOSITION**

(30) Priority: 26.12.2012 JP 2012283342
(71) Applicant: Momentive Performance Materials Japan LLC, Tokyo 107-6119 (JP)
(72) Inventor: TAKANASHI, Masanori, Tokyo 107-6119 (JP); IWABUCHI, Tatsuru, Tokyo 107-6119 (JP)
(74) Representative: Müller-Boré & Partner Patentanwälte PartG mbB
(86) International application number: PCT/JP2013/084635
(87) International publication number: WO 2014/104080

(57) **Abstract**

The present invention provides a material that is cured to efficiently reflect light in the violet and/or ultraviolet wavelength range emitted by optical elements such as LEDs. The present invention relates to a curable polyorganosiloxane composition which contains (A) an alkenyl group-containing polyorganosiloxane having at least two alkenyl groups, each bonded to a silicon atom, per molecule; (B) a polyorganohydrogensiloxane having more than two hydrogen atoms, each bonded to a silicon atom, per molecule; (C) a polyorganosiloxane represented by formula (II): wherein W is independently a polyorganosiloxane represented by general formula (II'): wherein R^{3a} is independently a C₂-C₆ alkenyl group or a C₁-C₆ alkyl group, R^{3b} is independently a C₁-C₆ alkyl group, L is a C₂-C₆ alkylene chain, and m is a number of 5 to 400, Y is an organosilicon group having a side chain bonded to a silicon atom and represented by general formula (III): wherein: Q¹ represents a linear or branched alkylene group that forms a carbon chain having two or more carbon atoms between the silicon atom and an ester bond, and Q² represents a linear or branched alkylene group that forms a carbon chain having three or more carbon atoms between an oxygen atom and a silicon atom in a side chain: SiR⁴ᵣ(OR⁴)₃₋ᵣ; R⁴ independently represents an unsubstituted or substituted alkyl group with 1 to 6 carbon atoms, t is 1, 2 or 3, and s is 0 or 1; provided that if s is 0, t is 1, and W is bonded to the silicon atom in the side chain: SiR⁴ᵣ(OR⁴)₃₋ᵣ, and if s is 1, t is 1, 2 or 3, and W is independently bonded to the silicon atom in Y, and r is 0 or 1; (D) alumina having an average particle diameter of 5 µm or less; and (E) a platinum-group metal compound, wherein component (D) is 50 to 1000 parts by weight based on a total of 100 parts by weight of Components (A), (B) and (C).

## Description

### TECHNICAL FIELD

The present invention relates to a polyorganosiloxane composition that cures though an addition reaction, and, in particular, to a polyorganosiloxane composition that gives, when cured, a cured product suitable as e.g., adhesives and/or reflective materials for optical elements.

### BACKGROUND ART

It is desirable for adhesives that fix optical elements, such as light emitting diodes (LEDs), to a substrate or for reflective materials that reflect light emitted by optical elements to be white in color and highly reflective.

Patent Document 1 describes a silicone adhesive for use as a die bonding material in semiconductor devices that exhibits a high degree of shielding and effectively reflects light emitted from an LED, and also exhibits favorable chip positioning properties, high adhesive strength and superior durability.

Patent Document 2 describes a white, heat-curable silicone resin composition used to form an optical semiconductor case. The composition contains titanium oxide, as a white pigment, that is surface-treated with alumina, or silica and alumina, and that has a unit lattice with an anatase structure. This allows the composition to maintain high light reflectance in a wavelength range of 350 to 400 nm. The document also describes an optical-semiconductor case made of a cured product of the composition for use for light emitting diodes (LEDs), for example.

Patent Document 3 describes an addition-curable silicone resin composition that gives a cured product that retains whiteness, heat resistance and light resistance; has superior moldability and dimensional stability; shows less deterioration in heat resistance over time and less yellowing due to UV deterioration; and exhibits high light reflectivity.

Patent Document 4 describes a white heat-curable silicone resin composition used to form an optical semiconductor case that retains whiteness, heat resistance and light resistance, is homogeneous and has less yellowing and has a reflectance of 80% or more in a region of wavelength 350 to 400 nm. The document also describes an optical semiconductor case for LEDs etc. made of a cured product of the composition.

### RELATED ART DOCUMENTS

### PATENT DOCUMENTS

Patent Document 1: Japanese Laid-open [Kokai] Patent Publication No. 2009-256400
Patent Document 2: Japanese Laid-open [Kokai] Patent Publication No. 2011-54902
Patent Document 3: Japanese Laid-open [Kokai] Patent Publication No. 2011-140550
Patent Document 4: Japanese Laid-open [Kokai] Patent Publication No. 2010-21533

### SUMMARY OF THE INVENTION

### PROBLEM TO BE SOLVED BY THE INVENTION

White pigments such as silica, titanium oxide, zinc oxide, calcium carbonate, alumina and titanium oxide have conventionally been used to color adhesives for optical elements white. Reflectance for light of a particular wavelength, however, varies with the types of white pigments. Titanium oxide or zinc oxide reflects light, for example, in the visible light region well, but they have a drawback in that they tend to absorb light in the near-ultraviolet region, and not reflect it. Silicon dioxide or calcium carbonate is not observed to absorb light in the near-ultraviolet region, but they have a drawback in that they have low reflectance for light in the wavelength region of 300 to 800 nm.

Meanwhile, there is recently an increasing need for optical elements, such as LED elements, that emit light having a shorter wavelength, for example, violet light or ultraviolet light rather than blue light. When, however, titanium oxide or zinc oxide is used in adhesives for such optical elements, light having a shorter wavelength may be absorbed or light output efficiency may decrease, for example. To overcome such problems, materials that can efficiently reflect such light of shorter wavelengths are needed.

Patent Document 4 suggests that alumina having an average particle diameter of 0.1 to 3.0 µm works as a white pigment, and alumina as a white pigment has an effect to reflect light, specifically, an effect to reflect 80% or more of light in a wavelength region of 400 nm or less; that incorporating alumina having a particle diameter in a microfine region into a composition, however, causes significant thickening; and that, for this reason, alumina cannot be incorporated in a large amount and is used in combination with magnesium oxide.

An object of the present invention is to provide a material that efficiently reflects light in the violet and/or ultraviolet light wavelength region(s) emitted by optical elements, such as LEDs.

### MEANS FOR SOLVING THE PROBLEM

As a result of extensive studies to solve these problems, the present inventors have found that a curable polyorganosiloxane composition containing a specific amount of alumina having a specific particle diameter exhibits favorable reflectivity over a wide range of wavelength region, and has achieved the present invention.

That is, the present invention relates to a curable polyorganosiloxane composition, which contains:
(A) an alkenyl group-containing polyorganosiloxane having at least two alkenyl groups, each bonded to a silicon atom, per molecule;
(B) a polyorganohydrogensiloxane having more than two hydrogen atoms, each bonded to a silicon atom, per molecule;
(C) a polyorganosiloxane represented by formula (II):

   Wₜ-Yₛ-SiR⁴ᵣ(OR⁴)₃₋ᵣ (II)

   wherein:
   W is independently a polyorganosiloxane group represented by the following general formula (II'): 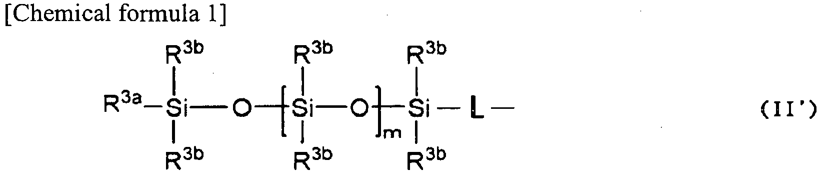 wherein:
      R^{3a} is a C₂-C₆alkenyl group or a C₁-C₆alkyl group,
      R³⁶ is independently a C₁-C₆alkyl group,
      L is a C₂-C₆alkylene chain, and
      m is a number of 5 to 400,
   Y is an organosilicon group having a side chain bonded to a silicon atom and represented by the following general formula (III): 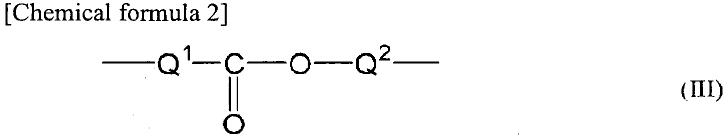 wherein:
      Q¹ represents a linear or branched alkylene group that forms a carbon chain having two or more carbon atoms between the silicon atom and an ester bond, and
      Q² represents a linear or branched alkylene group that forms a carbon chain having three or more carbon atoms between an oxygen atom and a silicon atom in a side chain: SiR⁴ᵣ(OR⁴)₃₋ᵣ,
   R⁴ independently represents an unsubstituted or substituted alkyl group with 1 to 6 carbon atoms,
   t is 1, 2 or 3, and s is 0 or 1; provided that if s is 0, t is 1, and W is bonded to the silicon atom in the side chain: SiR⁴ᵣ(OR⁴)₃₋ᵣ, and if s is 1, t is 1, 2 or 3, and W is independently bonded to the silicon atom in Y, and
   r is 0 or 1;
(D) alumina having an average particle diameter of 5 µm or less; and
(E) a platinum-group metal compound,
wherein Component (D) is 50 to 1000 parts by weight based on a total of 100 parts by weight of Components (A), (B) and (C).

The present invention also relates to an adhesive containing the above-described curable polyorganosiloxane composition, and a semiconductor·electronic device in which an optical element is fixed to a substrate using the adhesive.

The present invention further relates to a cured product obtained by curing the curable polyorganosiloxane composition, a cured product thereof as a reflective material, and a semiconductor·electronic device including such a reflective material.

### EFFECT OF THE INVENTION

The present invention provides a cured product of the curable polyorganosiloxane composition that exhibits favorable reflectivity in a wide wavelength region. The cured product of the present invention has high reflectance in the violet and/or ultraviolet region, in particular, in the near-ultraviolet region of 400 nm or less (especially, 350 to 400 nm).

### BRIEF DESCRIPTION OF THE DRAWINGS

Fig. 1 is a graph showing light reflectance values of Example 1 and Comparative Examples 4 to 8 at the wavelengths.
Fig. 2 is a graph showing light reflectance values of Examples 1 to 8 and Comparative Examples 1 to 3 at the wavelengths.

### MODE FOR CARRYING OUT THE INVENTION

### (A) Alkenyl group-containing polyorganosiloxane

The polyorganosiloxane composition of the present invention contains (A) an alkenyl group-containing polyorganosiloxane having at least two alkenyl groups, each bonded to a silicon atom, per molecule. This alkenyl group-containing polyorganosiloxane is a component that serves as a base polymer, and is a linear or branched polyorganosiloxane, and is more preferably composed of a linear polyorganosiloxane and a branched polyorganosiloxane.

The alkenyl groups, each bonded to a silicon atom, may be branched or linear, and the examples include a C₂-C₆alkenyl group, such as vinyl, allyl, 3-butenyl and 5-hexenyl. A vinyl group is most preferable for ease of synthesis, while not impairing the fluidity of the composition and the heat resistance of the cured product.

At least two of such alkenyl groups, each bonded to a silicon atom, are present per molecule. In this case, although the alkenyl groups may be present in any siloxane unit per molecule, at least part of the alkenyl groups is preferably present at a molecular terminal to obtain good reactivity.

In addition to such alkenyl groups, the above-described alkenyl group-containing polyorganosiloxane may contain an organic group bonded to silicon. Examples of such organic groups include unsubstituted or substituted, monovalent aliphatic groups or alicyclic groups containing no aliphatic unsaturated carbon-carbon bond, or unsubstituted or substituted aryl groups. Examples of the above-described aliphatic group or alicyclic group include alkyl groups, such as methyl, ethyl, propyl, butyl, pentyl, hexyl, octyl, decyl and dodecyl; cycloalkyl groups, such as cyclohexyl; monovalent aliphatic groups or alicyclic groups substituted by halogen (for example, chloro or fluoro) or cyano, such as chloromethyl, 2-cyanoethyl and 3,3,3-trifluoropropyl, and examples of the above-described aryl group include a phenyl group. A methyl group and a phenyl group are preferable in view of the heat resistance.

As the above-described Component (A), (A1) a linear polyorganosiloxane may be used, which is represented by formula (I): 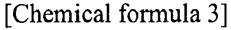 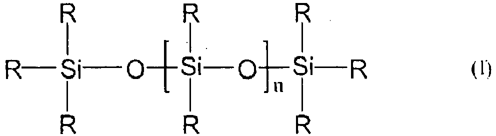 wherein:
R is independently R¹ or R², and at least two Rs are R¹;
R¹ is independently a C₂-C₆alkenyl group;
R² is independently a C₁-C₆alkyl group or aryl group; and
n is a number that provides a viscosity at 23°C of 10 to 10,000 cP.

Component (A1) preferably has a low viscosity of, for example, 10 to 3,000 cP so that a larger amount of Component (D) of the present invention can be incorporated. Here, the viscosity is measured in accordance with the rotational viscosity measurement method as set forth in JIS K6249 7.1.

Furthermore, Component (A) is preferably composed of Component (A1); and (A2) a branched polyorganosiloxane including SiO_{4/2} units and R'₃SiO_{1/2} units, and optionally further including R'₂SiO units and/or R'SiO_{3/2} units (wherein R' is each independently an unsubstituted or substituted monovalent aliphatic group or alicyclic group), wherein at least three of R's per molecule are preferably alkenyl groups.

Component (A1) is a linear polyorganosiloxane represented by the above-described formula (I), and can be a base polymer alone or in combination with Component (A2).

In the formula (I), R¹ is a C₂-C₆alkenyl group, which may be branched or linear, and the examples include vinyl, allyl, 3-butenyl and 5-hexenyl. A vinyl group is most preferable for ease in synthesize, while not impairing the fluidity of the composition and the heat resistance of the cured product.

In the formula (I), at least two R¹s are present. In this case, although the R¹s may be present in any siloxane unit per molecule, at least part of the R¹ s is preferably present at a terminal of the molecule, and more preferably one R¹ is present at each terminal, i.e., two R¹s in total at the terminals to obtain good reactivity.

In the formula (I), R² is a C₁-C₆alkyl group or aryl group. The C₁-C₆alkyl group may be branched or linear, and the examples include methyl, ethyl and propyl. Examples of the aryl group include a phenyl group. A methyl group or a phenyl group is particularly preferable for ease of synthesis and handling and to yield a cured product that exhibits superior thermal and mechanical properties.

In the formula (I), n is a number that provides Component (A1) a viscosity at 23°C of 10 to 10,000 cP. A viscosity in this range imparts Component (A1) with mechanical properties as well as a viscous property that renders the component easy to handle in combination use with Component (A2). The viscosity is preferably 20 to 5,000 cP, more preferably 50 to 2,500 cP and further preferably 150 to 2,500 cP. The viscosity is measured in accordance with the rotational viscosity measurement method as set forth in JIS K6249 7.1.

Component (A2) is a branched polyorganosiloxane, and constitutes a base polymer together with Component (A1), and imparts, in particular, superior mechanical strength to the cured product.

Component (A2) includes SiO_{4/2} units and R'₃SiO_{1/2} units, and optionally further includes R'₂SiO units and/or R'SiO_{3/2} units (wherein R' is each independently an unsubstituted or substituted, monovalent aliphatic group or alicyclic group), and at least three R's per molecule are alkenyl groups so as to serve as a crosslinking point in the curing reaction. Component (A2) is preferably a solid or a viscous semi-solid resinous or liquid substance at ambient temperature.

In (A2), the molar ratio of R'₃SiO_{1/2} units to SiO_{4/2} units (molar number of R'₃SiO_{1/2} units/molar number of SiO_{4/2} units) is preferably 0.25 to 1.5. When the molar ratio is in this range, superior mechanical strength is imparted to a cured product. The molar ratio is preferably 0.4 to 1.2 and more preferably 0.5 to 1.0.

When R' is an alkenyl group, it may be a C₂-C₆alkenyl group. It may be branched or linear, and the examples include vinyl, allyl, 3-butenyl and 5-hexenyl. A vinyl group is most preferable for ease of synthesis while not impairing the fluidity of the composition before curing and the heat resistance of the composition after curing.

The alkenyl group may be present as R' in R'₃SiO_{1/2} units. Although the alkenyl group may optionally be present as R' in R'₂SiO units or R'SiO_{3/2} units, at least part of the alkenyl groups is preferably present in R'₃SiO_{1/2} units to accelerate curing at room temperature.

Besides an alkenyl group, R' may be an unsubstituted or substituted, monovalent aliphatic group or alicyclic group containing no aliphatic unsaturated carbon-carbon bond, and the examples include an alkyl group, such as methyl, ethyl, propyl, butyl, pentyl, hexyl, octyl, decyl and dodecyl; a cycloalkyl group such as cyclohexyl; a monovalent aliphatic group or alicyclic group substituted by halogen (e.g., chloro or fluoro) or cyano, such as chloromethyl, 2-cyanoethyl and 3,3,3-trifluoropropyl. A methyl group is preferable in view of heat resistance.

In the polyorganosiloxane composition of the present invention, although the weight ratio of (A2) to (A1) (weight of (A2)/weight of (A1)) is not particularly limited, it is preferably 1 to 5, more preferably 1 to 4 and most preferably 1.5 to 2.5 to impart a greater hardness to the cured product.

In the polyorganosiloxane composition of the present invention, although the weight ratio of SiO_{4/2} units and optionally present R'SiO_{3/2} units in (A1) and (A2) in total, is not particularly limited, it is preferably 20 to 70 wt% to impart a superior mechanical strength to the cured product.

### (B) Polyorganohydrogensiloxane

The curable polyorganosiloxane composition of the present invention contains (B) a polyorganohydrogensiloxane having more than two hydrogen atoms, each bonded to a silicon atom, per molecule.

(B) serves as a crosslinking agent for (A) through an addition reaction between a hydrosilyl group in its molecule and an alkenyl group in (A). Such (B) has more than two hydrosilyl groups, and preferably three or more hydrosilyl groups involved in such an addition reaction per molecule so that the cured product has a reticular structure.

Component (B) typically includes a unit represented by the general formula (IV):

(R⁵)_{c}H_{d}SiO_{(4-c-d)/2} (IV)

wherein:
R⁵ represents an unsubstituted or substituted, monovalent aliphatic group or alicyclic group containing no aliphatic unsaturated carbon-carbon bond;
c is an integer of 0 to 2; and
d is 1 or 2; provided that c+d is an integer of 1 to 3
in a number exceeding two and preferably three or more, per molecule. The units may be the same or different.

Examples of R⁵ and an organic group bonded to a silicon atom in other siloxane units in (B) are the same as those for R' in the (A2) except for an alkenyl group. Of them, a methyl group is most preferable for ease of synthesis. Furthermore, d is preferably 1 for ease of synthesis.

The siloxane skeleton in (B) may be any of linear, branched and cyclic. A mixture of these may also be used.

Although the degree of polymerization of (B) is not particularly limited, (B) is preferably composed of three or more siloxane units, because it is difficult to synthesize a polyorganohydrogensiloxane in which two or more hydrogen atoms are bonded to the same silicon atom. The number of the siloxane units is more preferably 6 to 200 and particularly preferably 10 to 150 so that (B) does not volatilize when heated to a curing temperature and has superior fluidity so as to be easily mixed with (A).

As (B), a polyorganohydrogensiloxane may be preferably used, which is represented by formula (IV'):

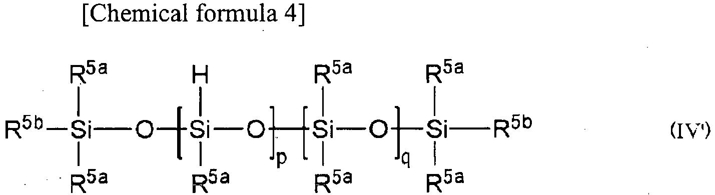

wherein R^{5a} is independently an unsubstituted or substituted, monovalent aliphatic group or alicyclic group containing no aliphatic unsaturated carbon-carbon bond; R^{5b} is independently a hydrogen atom, or an unsubstituted or substituted, monovalent aliphatic group or alicyclic group; p is a number from 2 to 100 and preferably 3 to 50; and q is a number from 0 to 100 and preferably 3 to 50.

Examples, for R^{5a} and R^{5b}, of the unsubstituted or substituted, monovalent aliphatic group or alicyclic group containing no aliphatic unsaturated carbon-carbon bond include alkyl groups, such as methyl, ethyl, propyl, butyl, pentyl, hexyl, octyl, decyl and dodecyl; cycloalkyl groups such as cyclohexyl; monovalent aliphatic groups or alicyclic groups substituted by halogen (for example, chloro or fluoro) or cyano, such as chloromethyl, 2-cyanoethyl and 3,3,3-trifluoropropyl. In view of heat resistance, a methyl group is preferable.

To yield a cured product having superior mechanical properties, the amount of (B) is preferably contained so that the ratio of the number of hydrogen atoms (H_{B}) bonded to the silicon atoms in (B) to the number of alkenyl groups (Vi_{A}) bonded to the silicon atoms in (A) (H_{B}/Vi_{A}) is 0.3 to 5. With H_{B}/Vi_{A} in this range, the mechanical strength and heat resistance of the cured product are sufficient and bubbling at the time of curing can be reduced or prevented. H_{B}/Vi_{A} is more preferably 0.5 to 5 and most preferably 0.7 to 2.

### (C) Organosilicon group-containing polyorganosiloxane

The polyorganosiloxane composition of the present invention contains (C) a polyorganosiloxane represented by formula (II):

Wₜ-Yₛ-SiR⁴ᵣ(OR⁴)₃₋ᵣ (II)

wherein:
W is independently a polyorganosiloxane group represented by the following general formula (II'): 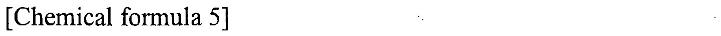 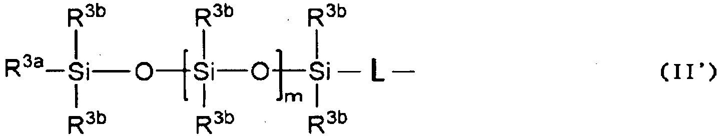 wherein:
   R^{3a} is a C₂-C₆alkenyl group or a C₁-C₆alkyl group;
   R^{3b} is independently a C₁-C₆alkyl group;
   L is a C₂-C₆alkylene chain; and
   m is a number of 5 to 400;
Y is an organosilicon group having a side chain bonded to a silicon atom and represented by the following general formula (III): 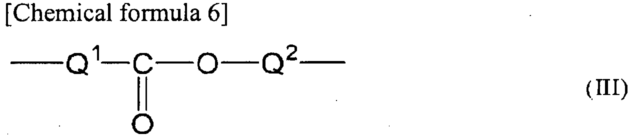 wherein:
   Q¹ represents a linear or branched alkylene group that forms a carbon chain having two or more carbon atoms between the silicon atom and an ester bond, and
   Q² represents a linear or branched alkylene group that forms a carbon chain having three or more carbon atoms between an oxygen atom and a silicon atom in a side chain: SiR⁴ᵣ(OR⁴)₃₋ᵣ;
   R⁴ independently represents an unsubstituted or substituted alkyl group with 1 to 6 carbon atoms,
   t is 1, 2 or 3; s is 0 or 1; provided that if s is 0, t is 1 and W is bonded to the silicon atom in the side chain: SiR⁴ᵣ(OR⁴)₃₋ᵣ, and if s is 1, t is 1, 2 or 3 and W is independently bonded to the silicon atom of Y, and
   r is 0 or 1.

In the above-described formula (II'), the C₂-C₆alkenyl group for R^{3a} may be branched or linear and the examples include vinyl, allyl, 3-butenyl and 5-hexenyl. R^{3a} at a terminal of polyorganosiloxane of formula (II) is preferably a C₂-C₆alkenyl group, in particular, a vinyl group in view of the properties for the surface treatment of the filler.

In the formula (II'), the C₁-C₆alkyl group for both R^{3a} and R^{3b} may be branched or linear, and the examples include methyl, ethyl and propyl. A methyl group is particularly preferable for ease of synthesis and handling, and to yield a cured product that has superior thermal properties and mechanical properties.

In the formula (II'), the C₂-C₆alkylene chain for L may be branched or linear, and the examples include an ethylene chain and a propylene chain. The C₂-C₆alkylene chain for L is preferably an ethylene chain for ease in industrial scale synthesis of the polyorganosiloxane of the formula (II) through an addition reaction between a hydrogen atom bonded to silicon and an unsaturated group bonded to silicon.

In the formula (II'), m is a number of 5 to 400, preferably a number of 10 to 250, and more preferably a number of 20 to 200. With m in this range, the linear polyorganosiloxane of formula (IIa) described below has a viscosity at 23°C in the range of 5 to 1,000 cP, preferably 10 to 500 cP, and more preferably 20 to 300 cP, achieving mechanical properties and a workable viscosity. The degree of viscosity is a numerical value measured in accordance with the rotational viscosity method as set forth in JIS K6249 7.1.

In the formula (II), an organosilicon group for Y is, for example, an organosiloxane oligomer residue with 2 to 50 silicon atoms, and preferably 4 to 20 silicon atoms, having a side chain bonded to a silicon atom and represented by the formula (III).

In the organosilicon group, any organic group may be bonded to the silicon atom. Examples of such organic groups include unsubstituted or substituted, monovalent aliphatic groups or alicyclic groups containing no aliphatic unsaturated carbon-carbon bond, and the examples include alkyl groups, such as methyl, ethyl, propyl, butyl, pentyl, hexyl, octyl, decyl and dodecyl; cycloalkyl groups, such as cyclohexyl; monovalent aliphatic groups or alicyclic groups substituted by halogen (for example, chloro or fluoro) or cyano, such as chloromethyl, 2-cyanoethyl and 3,3,3-trifluoropropyl.

Such organosilicon groups preferably have an alkoxy group and/or an alkenyloxy group bonded to the silicon atom, and at least one reactive functional group selected from an Si-H group, an alkenyl group, an acrylic group, a methacrylic group, an epoxy group, a mercapto group, an ester group, an anhydrous carboxylic group, an amino group and an amide group. These may have only one or more than one type.

In the side chain represented by the general formula (III), examples of Q¹ include alkylene groups, such as ethylene, trimethylene, 2-methylethylene and tetramethylene. Of these, an ethylene group and a 2-methylethylene group are preferable for ease of synthesis and handling. Examples of Q² include alkylene groups, such as trimethylene, 2-methyltrimethylene and tetramethylene. Of these, a trimethylene group is preferable for ease of synthesis and handling.

Examples of such an organosilicon group include the following group. 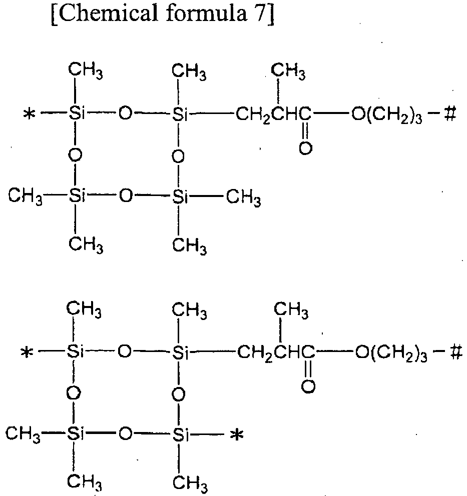 wherein * indicates a bonding site with W, and # indicates a bonding site with the silicon atom in the side chain: SiR⁴ᵣ(OR⁴)₃₋ᵣ.

In the formula (II), t is 1, 2 or 3, and preferably 1 or 2 for ease of synthesis. In the formula (II), s is 0 or 1, and preferably 1 for ease in industrial scale synthesis.

However, if s is 0, t is 1. In this case, in formula (II), one W is present, but Y is not present, and W is bonded directly to the silicon atom in the side chain: SiR⁴ᵣ(OR⁴)₃₋ᵣ. When s is 1, t is 1, 2 or 3. In this case, one, two or three Ws are present, one Y is present, and W is independently bonded to the silicon atom of Y in the formula (II). Here, "W is independently bonded to the silicon atom of Y" means that a plurality of Ws each separately bind directly to the silicon atom of Y. Specifically, the formula (II) may have the following structure: 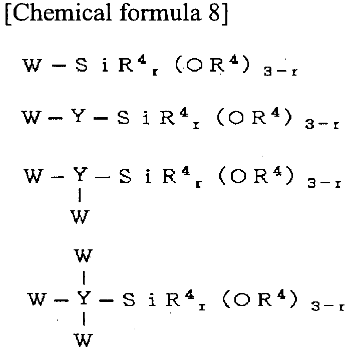 wherein W, Y, R⁴ and r are as defined in the formula (II).

When two or three Ws are present in the formula (II), the Ws may be the same or different, and are preferably the same. Further, the Ws may be bonded to the same or different silicon atom(s) of Y, but are preferably bonded to different silicon atoms.

In the formula (II), examples of R⁴ include alkyl groups, such as methyl, ethyl, propyl, isopropyl and butyl; and alkoxy-substituted alkyl groups, such as 2-methoxyethyl. To impart good reactivity with Component D and to reduce the viscosity of the composition, a methyl group and an ethyl group are preferable, and a methyl group is particularly preferable. When more than one R⁴ are present in the formula (II), they may be the same or different.

Additionally, in the formula (II), r is 0 or 1. For the surface-treatment of the filler, r is preferably 0 because the composition is more reactive and the effect of the surface treatment is higher when there are three -OR4s, in other words, a high viscosity reduction effect is achieved with a little amount of addition.

The organosilicon group-containing polyorganosiloxane represented by the formula (II) is obtained, for example, by adding to a linear polyorganosiloxane represented by the following formula (IIa): 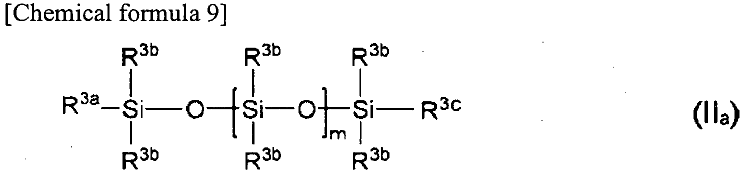 wherein R^{3a}, R^{3b} and m are as defined in the formula (II), and R^{3c} is a C₂-C₆alkenyl group,
an organosilicon compound represented by the following formula (IIb):

Y'-SiR⁴ᵣ(OR⁴)₃₋ᵣ (IIb)

wherein Y' is a hydrogen atom, or an organosilicon group as defined previously for Y (provided, however, that the organosilicon group has 1 to 3 Si-H groups); R⁴ and r are as defined in the formula (II),
for example, with a platinum catalyst.

R^{3a} is preferably a C₂-C₆alkenyl group, in particular, a vinyl group for ease in industrial scale synthesis of a linear polyorganosiloxane of formula (IIa). For the same reason, R^{3c} is also preferably a vinyl group.

In the present invention, Component (C) can reduce thickening of the composition that may be caused by alumina. Although the amount of Component (C) can be changed usually according to the specific surface area of alumina, the amount is not particularly limited as long as the thickening of the composition due to the presence of alumina is reduced. The amount may be, for example, 0.1 wt% or more, preferably 1 wt% or more, relative to alumina, to reduce the thickening of the composition, and 20 wt% or less, preferably 10 wt% or less to prevent deterioration in the mechanical strength of the resultant cured product.

### (D) Alumina having an average particle diameter of 5 µm or less

The curable polyorganosiloxane composition of the present invention contains (D) alumina having an average particle diameter of 5 µm or less. The average particle diameter of (D) needs to be 5 µm or less to provide a cured product that exhibits good reflectivity in the near-ultraviolet region, and is particularly preferably 0.1 to 3 µm, and especially preferably 0.1 to 1 µm.

The average particle diameter of the present invention is a mass average value D₅₀ (or median size) in a particle size distribution measurement by a laser optical diffraction method.

In the present invention, the shape of (D) is not particularly limited, and may be amorphous or spherical, but it is preferably spherical to provide a cured product that exhibits good reflectivity in the near-ultraviolet region.

In the composition of the present invention, thickening due to the inclusion of alumina can be reduced by incorporating Component (C), and thus a higher amount of (D) alumina may be contained. Therefore, even if the composition of the present invention contains no magnesium oxide, its cured product can exhibit good reflectivity in the near-ultraviolet region (350 to 400 nm). The present invention also relates to a curable polyorganosiloxane composition that contains substantially no magnesium oxide.

The composition of the present invention contains 50 to 1000 parts by weight of Component (D) based on a total of 100 parts by weight of Components (A), (B) and (C). With the amount of Component (D) in this range, a cured product that exhibits good reflectivity in the near-ultraviolet region can be provided. The amount of Component (D) is preferably 75 to 750 parts by weight, and more preferably 100 to 500 parts by weight based on a total of 100 parts by weight of Components (A), (B) and (C).

### (E) Platinum-group metal compound

The polyorganosiloxane composition of the present invention contains (E) a platinum-group metal compound. Component (E) functions as a catalyst to promote an addition reaction between the alkenyl groups bonded to the silicon atoms in (A) and the hydrosilyl groups in (B). Examples of such platinum-group metal compounds include compounds of platinum group metal atoms, such as platinum, rhodium and palladium. Specific examples include platinum compounds, such as chloroplatinic acid, a reaction product of chloroplatinic acid and an alcohol, a platinum-olefin complex, a platinum-vinylsiloxane complex, a platinum-ketone complex and a platinum-phosphine complex; rhodium compounds, such as a rhodium-phosphine complex and a rhodium-sulfide complex; and palladium compounds, such as a palladium-phosphine complex.

Of these, reaction products of chloroplatinic acid and an alcohol, for example, catalyst Ramoro (platinum-octanol complex, US Patent No. 473,377), and a platinum-vinylsiloxane complex are preferable, because of their favorable catalytic activities. To accelerate curing of the composition to exhibit adhesiveness in a short period of time, a platinum-1,3-divinyl-1,1,3,3-tetramethyldisiloxane complex and a platinum-1,3,5,7-tetravinyl-1,3,5,7-tetramethylcyclotetrasiloxane are preferable. The required curing rate, however, may vary depending on the shape of the portion to which a cured product is provided and the working time necessitated accordingly. Thus, the curing rate may be selected depending on the combination of Component (E) and a curing inhibitor.

The amount of (E) is usually 0.1 to 1,000 wt ppm, preferably 0.5 to 100 wt ppm in platinum-group metal atom equivalent terms based on the total amount of Component (A) and Component (B) to achieve a superior curing rate. In case of 0.1 wt ppm or more, the curing rate becomes higher, and in case of 1,000 wt ppm or less, the curing rate increases to an extent matching it.

The curable polyorganosiloxane composition of the present invention may contain an adhesion promoter as necessary, within a range not to inhibit the catalytic activity of Component (E). Examples of such adhesion promoters include 3-glycidoxypropyl group-containing alkoxysilanes, such as 3-glycidoxypropyltrimethoxysilane, 3-glycidoxypropyltriethoxysilane and 3-glycidoxypropyl(methyl)dimethoxysilane; 2-(3,4-epoxycyclohexyl)ethyl group-containing alkoxysilanes, such as 2-(3,4-epoxycyclohexyl)ethyltrimethoxysilane, 2-(3,4-epoxycyclohexyl)ethyltriethoxysilane and 2-(3,4-epoxycyclohexyl)ethyl(methyl)dimethoxysilane; alkenylalkoxysilanes, such as vinyltrimethoxysilane, vinyltriethoxysilane, vinyltris(2-methoxyethoxy)silane, methylvinyldimethoxysilane, allyltrimethoxysilane, allyltriethoxysilane and methylallyldimethoxysilane; (meth)acryloxypropylalkoxysilanes, such as 3-acryloxy propyltrimethoxysilane, 3-acryloxypropyltriethoxysilane, 3-acryloxypropyl(methyl)dimethoxysilane, 3-methacryloxypropyltrimethoxysilane, 3-methacryloxypropyltriethoxysilane and 3-methacryloxypropyl(methyl)dimethoxysilane; organosilicon compounds containing a hydrogen atom bonded to a silicon atom and a side chain bonded to a silicon atom represented by the following general formula (V):

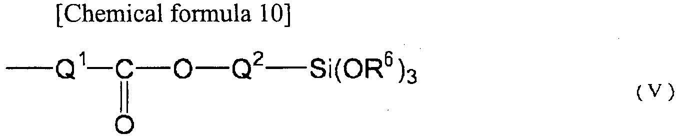

wherein Q¹ represents a linear or branched alkylene group that forms a carbon chain having two or more carbon atoms between the silicon atom and an ester bond; Q² represents a linear or branched alkylene group that forms a carbon chain having three or more carbon atoms between an oxygen atom and a silicon atom in a side chain; R⁶ represents an unsubstituted or substituted alkyl group with 1 to 6 carbon atoms; aluminium alkoxides, such as aluminium triethoxide, aluminium tripropoxide and aluminium tributoxide; titanium alkoxides, such as titanium tetraethoxide, titanium tetrapropoxide, titanium tetraisopropoxide, titanium tetrabutoxide, titanium tetraisobutoxide and titanium tetraisopropenyl oxide; zirconium alkoxides, such as zirconium tetraisopropoxide and zirconium tetrabutoxide; polar group-containing organic compounds, such as diallyl maleate and triallyl isocyanate.

In the side chain represented by the above-described general formula (V), examples of Q¹ include alkylene groups, such as ethylene, trimethylene, 2-methylethylene and tetramethylene. Of these, an ethylene group and a 2-methylethylene group are preferable for ease of synthesis and handling. Examples of Q² include alkylene groups, such as trimethylene, 2-methyltrimethylene and tetramethylene. Of these, a trimethylene group is preferable for ease of synthesis and handling. Examples of R⁶ include alkyl groups, such as methyl, ethyl, propyl, isopropyl and butyl; and alkoxy-substituted alkyl groups, such as 2-methoxyethyl. Of these, a methyl group and an ethyl group are preferable, and a methyl group is particularly preferable, to impart a good adhesiveness and volatilize the alcohol generated by hydrolysis with ease. Examples of organosilicon compounds having such a side chain include a cyclic siloxane compound represented by formula (VI):

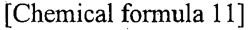

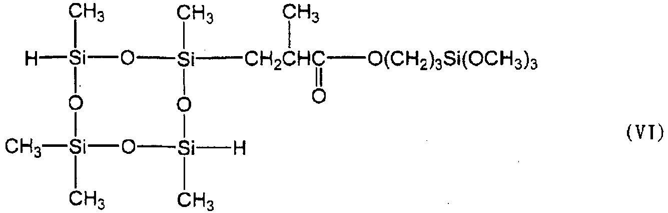

The amount of the adhesion promoter varies depending on the type of the adhesion promoter and the base. The amount is usually in the range of 0.01 to 20 parts by weight, preferably 0.1 to 10 parts by weight, and more preferably 0.5 to 5 parts by weight based on 100 parts by weight of Component (A), in view of adhesiveness, in particular.

To improve storage stability and workability of the curable polyorganosiloxane composition of the present invention, the composition may contain a curing inhibitor as long as the object of the present invention is not impaired. The above-described diallyl maleate is effective not only as an adhesion promoter but also as a curing inhibitor. Other examples of such curing inhibitors include acetylene alcohols, such as 3-methyl-1-butyn-3-ol, 3-methyl-1-pentyn-3-ol, 3,5-dimethyl-1-hexyn-3-ol and 1-ethynyl-1-cyclohexan-1-ol. The amount of the curing inhibitor may be selected depending on the desired curing rate.

The curable polyorganosiloxane composition of the present invention forms, when cured, a cured product that is suitable for use as an adhesive and/or a reflective material for optical elements. In addition to Component (D), an inorganic filler may be added to impart appropriate fluidity to the composition before curing, and high mechanical strength required for a use of the resultant cured product to the product, as long as the objects of the present invention are not impaired. Examples of such inorganic fillers include reinforcing fillers having an average particle diameter of less than 0.1 µm and a specific surface of 30 mm²/g or more; and non-reinforcing fillers having an average particle diameter of 0.1 to 50 µm. Examples of the reinforcing fillers include dry-process silicas, such as aerosol silica and arc silica; and wet-process silicas, such as precipitation silica. These may be used as they are, or may be used after being surface-treated with a hydrophobizing agent, such as hexamethyldisilazane. Examples of the non-reinforcing fillers include diatomaceous earth, ground quartz, fused quartz, titanium oxide, aluminium oxide, zinc oxide, aluminosilicate, calcium carbonate, organic acid surface-treated calcium carbonate, magnesium carbonate, zinc carbonate, calcium silicate, talc and ferric oxide. The filler may be selected depending on the extrusion workability and the physical properties required of the resultant cured product. Conductive fillers such as carbon black may be mixed depending on the purpose.

The amount of the inorganic filler may be 0 to 500 parts by weight and preferably 0 to 200 parts by weight based on 100 parts by weight of Component (A) in view of, particularly, durability, mechanical strength and workability (viscosity) of the cured product.

Furthermore, various additives may be added to the curable polyorganosiloxane composition of the present invention according to the intended use as long as the objects of the present invention are not impaired. Examples of such additives include a pigment, a thixotropic property-imparting agent, a viscosity adjuster for improving extrusion workability, an ultraviolet rays blocking agent, a fungicide, a heat resistance enhancer, a flame retardant and a chain length extender. Examples of such chain length extenders include linear hydrogen polyorganosiloxanes, which have one hydrogen atom bonded to a silicon atom at each terminal (for example, a linear polymethylsiloxane that is blocked with M^{H} unit: (CH₃)₂HSiO_{1/2}- at both terminals, and has intermediate units D units: -(CH₃)₂SiO-). The composition of the present invention may optionally be dissolved or dispersed in an organic solvent including aliphatic hydrocarbons, such as hexane and pentane, and aromatic hydrocarbons, such as toluene and xylene.

The curable polyorganosiloxane composition of the present invention may be prepared by uniformly kneading Components (A) to (E), and other components to be further added as necessary, using a mixing means, such as a universal kneader and a kneader. When Component (A) includes Component (A1) and Component (A2), and the Component (A2) is a solid or extremely viscous, such Component (A2) may be cohydrolyzed, to make it easier to handle, in the presence of an organic solvent, such as toluene and xylene, and treated as an organic solvent solution in the following steps. After such cohydrolyzed Component (A2) is mixed with Component (A1), the solvent may be distilled off by heating under reduced pressure as appropriate to yield Component (A).

For a long stable storage, two preparatory formulations may be appropriately prepared and stored so that Component (B) and Component (E) are contained separately in the distinct formulation. The two formulations may be homogenously mixed immediately before use, using a mixing means, such as a mixing head of a quantitative mixer to prepare a curable polyorganosiloxane composition, which may then be defoamed under reduced pressure before use.

The method of curing the curable polyorganosiloxane composition of the present invention is not particularly limited. The composition may be combined with a target object such as an optical element by methods, such as injecting, dropping, flow-casting, casting and extruding from a container the composition to a site to be used, or by being integrally molded by transfer-molding or injection-molding, and the resultant combination is cured by being left at room temperature or by heating to yield a cured product. Alternatively, the composition may be used to fix an optical element to a support member, followed by standing at room temperature or heating at 100 to 200°C for around 30 to 300 min.

The curing time may be suitably adjusted so that the composition is cured at 200°C or less, preferably at around 150°C to have stable properties. The curing time is preferably 5 hours or less and more preferably 3 hours or less. The curing conditions, however, may be appropriately adjusted depending on the size of the member and the capacity of the heating furnace.

The cured products of the curable polyorganosiloxane composition of the present invention have superior reflectivity for light, particularly, for light in the violet and/or ultraviolet region, and, especially, in the near-ultraviolet region of 400 nm or less (in particular, 350 to 400 nm). A cured product of the present invention having a thickness of 500 µm, for example, has a reflectance of usually 85% or more, preferably 90% or more, and more preferably 92% or more for light having a wavelength of 350 to 400 nm. The cured products of the present invention efficiently output light to the outside by reflecting light emitted by optical elements at high reflectance.

The optical element according to the present invention collectively refers to optical semiconductor devices, for example, semiconductor light emitting elements and semiconductor light receiving elements, such as light emitting diodes (LEDs) and laser diodes (LDs), photodiode (PDs), as well as light-emitting devices, such as xenon tubes.

### EXAMPLES

The present invention will be explained in more detail with reference to the following Examples and Comparative Examples. In these Examples, part(s) indicates part(s) by weight, and viscosity indicates viscosity at 23°C. The present invention is not limited to these Examples.

Siloxane units will be shown using the following symbols.
M unit: (CH₃)₃SiO_{1/2}-
M^{H} unit: (CH₃)₂HSiO_{1/2}-
M^{V} unit: (CH₃)₂(CH₂=CH)SiO_{1/2}-
D unit: -(CH₃)₂SiO-
D^{H} unit: -(CH₃)HSiO-
D^{Ph2} unit: -(Ph)₂SiO- (wherein Ph represents a phenyl group)
Q unit: SiO_{4/2} (tetrafunctional)

In Examples and Comparative Examples, the polyorganosiloxanes described below were used as Components (A), (B) and (C). In the unit formulas, the intermediate siloxane unit simply indicates the number of units. When a plurality of types of intermediate siloxane units is contained, such intermediate siloxane units are randomly arranged.

As Component (A), the following A1-1 to A1-4 and A2-1 were used.
A1-1: Linear polymethylvinylsiloxane in which both terminals are blocked with M^{V} units, the intermediate units are composed of D units, and the viscosity at 23°C is 250 cP;
A1-2: Linear polymethylvinylsiloxane in which both terminals are blocked with M^{V} units, the intermediate units are composed of D units, and the viscosity at 23°C is 3,000 cP;
A1-3: Linear polymethylvinylsiloxane in which both terminals are blocked with M^{V} units, the intermediate units are composed of D units, and the viscosity at 23°C is 50 cP;
A1-4: Linear polymethylvinylsiloxane in which both terminals are blocked with M^{V} units, the intermediate units are composed of 5 mol% of D^{Ph2} units and the remaining mol% of D units, and the viscosity at 23°C is 1,000 cP;
A2-1: Branched polymethylvinylsiloxane composed of M units, M^{v} units, and Q units, and the molar unit ratio is represented by M₅M^{v}Q₈.

As Component (B), the following B-1 to B-3 were used.
B-1: Linear polymethylhydrogensiloxane represented by MD^{H}₂₀D₂₀M in which both terminals are blocked with M units, and the intermediate units are composed of 50 mol% D^{H} units and the remaining mol% of D units;
B-2: Linear polymethylhydrogensiloxane represented by MD^{H}₅₀M in which both terminals are blocked with M units, and the intermediate units are composed of D^{H} units;
B-3: Branched polymethylhydrogensiloxane represented by an average composition formula: M^{H}₈Q₄, which is composed of M^{H} units and Q units.

As Component (C), C-1 to C-4 were used.
C-1 was obtained by adding C2-1 to C1-1 at 100°C, using E-1 as a platinum catalyst (platinum: 5 ppm relative to C1-1). In this reaction, the ratio of the number of hydrogen atoms bonded to the silicon atoms in C2-1 to the number of vinyl groups bonded to the silicon atoms in C1-1 is 0.1.
C-2 was obtained in the same manner as C-1 except that C1-2 was used in place of C1-1.
C-3 was obtained in the same manner as C-1 except that C1-2 was used in place of C1-1, and C2-2 was used in place of C2-1.
C-4 was obtained in the same manner as C-1 except that C1-3 was used in place of C1-1, and H-Si(OEt)₃ was used in place of C2-1.
C1-1 to C1-3, C2-1 and C2-2 are described below. E-1 will be described later.
C1-1: Linear polymethylvinylsiloxane in which both terminals are blocked with M^{V} units, and the intermediate units are composed of 90 D units;
C1-2: Linear polymethylvinylsiloxane in which one of the terminals is blocked with a M^{V} unit, and the other terminal is blocked with a M unit, and the intermediate units are composed of 50 D units;
C1-3: Linear polymethylvinylsiloxane in which both terminals are blocked with M^{V} units, and the intermediate units are composed of 200 D units;
C2-1: A compound represented by the following formula (VI): 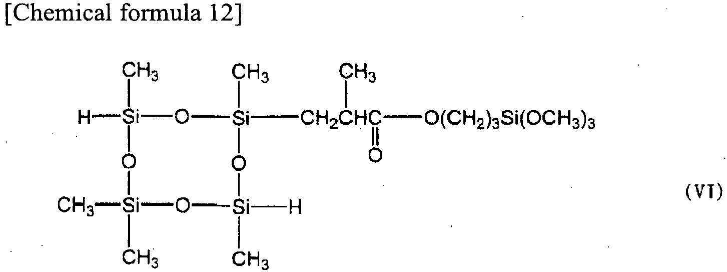
C2-2: A compound represented by the following formula (VI'):

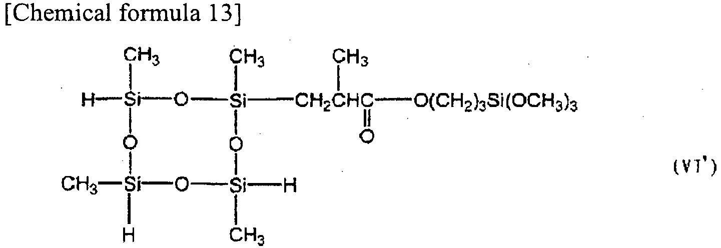

The following white pigments were used as Component (D) in Examples and Comparative Examples.
D-1: Spherical alumina having an average particle diameter of 0.4 µm (trade name: Sumicorandom AA-04, manufactured by Sumitomo-Kagaku Co., Ltd.)
D-2: Spherical alumina having an average particle diameter of 1.5 µm (trade name: Sumicorandom AA-1.5, manufactured by Sumitomo-Kagaku Co., Ltd.)
D-3: Spherical alumina having an average particle diameter of 3 µm (trade name: Sumicorandom AA-3, manufactured by Sumitomo-Kagaku Co., Ltd.)
D-4: Spherical alumina having an average particle diameter of 18 µm (trade name: Sumicorandom AA-18, manufactured by Sumitomo-Kagaku Co., Ltd.)
D-5: Amorphous alumina having an average particle diameter of 0.55 µm (trade name: Alumina AL-160SG-4, manufactured by Showa Denko K.K.)
D-6: Amorphous alumina having an average particle diameter of 2 µm (trade name: Alumina AL-30, manufactured by Showa Denko K.K.)
D-7: Amorphous alumina (trade name: alumina AS-40, manufactured by Showa Denko K.K.)
D-8: Titanium oxide having an average particle diameter of 0.15 µm (trade name: TIPAQUE A-100, manufactured by Ishihara Sangyo Kaisha, Ltd.)
D-9: Zinc oxide having an average particle diameter of 1 µm (trade name: AENKA No. 1, manufactured by Mitsui Mining and Smelting Co., Ltd.)
D-10: Barium titanate having an average particle diameter of 2 µm (trade name: BT-UP2, manufactured by Sakai Chemical Industry Co., Ltd)
D-11: Calcium carbonate having an average particle diameter of 1.7 µm (trade name: NS-400, manufactured by Nitto Funka Kogyo K.K.)
D-12: Silicon dioxide having an average particle diameter of 4 µm (trade name: CRYSTALITE VX-S, manufactured by Tatsumori. Ltd)
D-13: Amorphous alumina having an average particle diameter of 4.6 µm (trade name: Alumina AL-43KT, manufactured by Showa Denko K.K.)

The following platinum-group metal compounds were used as Component (E) (catalyst) in the Examples and Comparative Examples.
E-1: Catalyst Ramoro (platinum-octanol complex, Specification of US Patent No. 473377) (3.8 wt% in platinum metal atom equivalent terms).
E-2: Platinum-1,3,5,7-tetravinyl-1,3,5,7-tetramethylcyclotetrasiloxane (1.8 wt% in platinum metal atom equivalent terms).

The following was used as Component (F) (curing inhibitor) in the Examples and Comparative Examples.
F-1: 1-Ethynyl-1-cyclohexanol

The following were used as Component (G) (adhesion promoter) in the Examples and Comparative Examples.
G-1: 1,3,5-Triallyl isocyanurate
G-2: A product obtained by adding to B-1 described above 3-methacryloxypropyltrimethoxysilane in a molar ratio of 1:3
G-3: A partially hydrolyzed product of 3-glycidoxypropyltrimethoxysilane (trade name: Coatsil MP-200, manufactured by Momentive Performance Materials)

### Examples 1 to 17 and Comparative Examples 1 to 8

Polyorganosiloxane compositions were prepared by the following method according to the formulations as shown in Table 1.

A solution of Component (A) in toluene was added to a container equipped with a stirrer, a heater and a decompressor, and mixed so as to become homogenous. Subsequently, the toluene was distilled off at 150°C under 13kPa (1 torr) to prepare a polysiloxane solution. This solution was transferred to a universal kneader, and Components (C) and (D) were added. The mixture was kneaded at 150°C for three hours under reduced pressure, and then cooled to 40°C or less. Components (E), F-1 and G-1 were added and mixed. Subsequently, Components (B), G-2 and G-3 were added, and the mixture was defoamed by kneading under reduced pressure for 10 min to prepare a polyorganosiloxane composition. In Example 11, after the addition of the components, 10 parts by weight of an isoparaffin solvent (trade name: IPSolvent 1620, manufactured by Idemitsu Petroleum Chemical Co., Ltd.) was further added, and the mixture was kneaded under reduced pressure for 10 min.

The thus prepared polyorganosiloxane compositions were each cast into a sheet-like shape with a thickness of 250 µm or 500 µm, and cured by heating in an oven at 150°C for 1 hour to obtain cured products. The cured products were evaluated in the following tests.

### [Appearance]

The cured products were each visually inspected.

### [Reflectance]

Using a spectrophotometer [UV3600 (Integrating Sphere Attachment) manufactured by Shimadzu Corporation], reflectance on the surface was each measured, using barium sulphate as a standard substance, through continuous scanning in a wavelength region of 300 to 800 nm.

### [Hardness]

The prepared polyorganosiloxane compositions were each poured into a Teflon®-coated metal (aluminium) container having a size of 30 mm (height) x 60 mm (width) x 6 mm (depth), and the container was covered with a similarly Teflon®-coated metal lid. The compositions were each cured at 150°C for 1 hour in a hot air circulation dryer. Subsequently, after cooling to room temperature, the resultant cured products were removed from the metal molds, and the hardness (Type D) was measured (in accordance with JIS K6253).

### [Tensile shear adhesion strength and Cohesive failure]

Test pieces were prepared in accordance with JIS K6249 (an adherend: aluminium, thickness of an adhesion layer: 1.0 mm) from the prepared polyorganosiloxane compositions, and they were then cured at 150°C for 1 hour in the above-described dryer. The resultant cured products were each cooled to room temperature, and the tensile shear adhesion strength was measured at a tensile rate of 10 mm/min.

By observing the state of each test piece in the moment, products that exhibited cohesive failure and products that exhibited peeling were determined according to the following criteria, and a cohesive failure rate was calculated as the ratio between the two.
Cohesive failure: a state where silicone resin is fractured.
Peeling: a state where no silicone resin residue is left on the surface of the adherend.

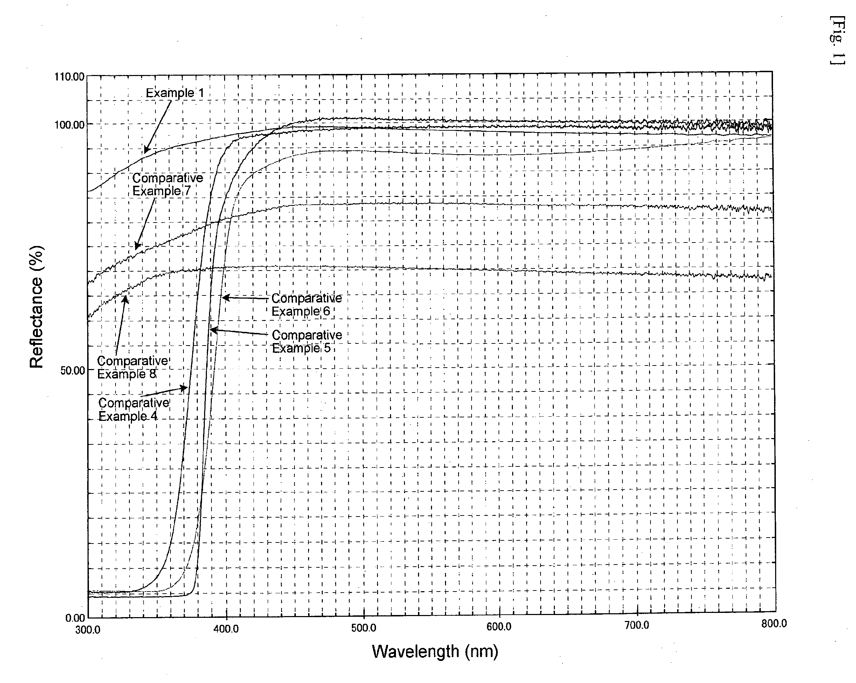

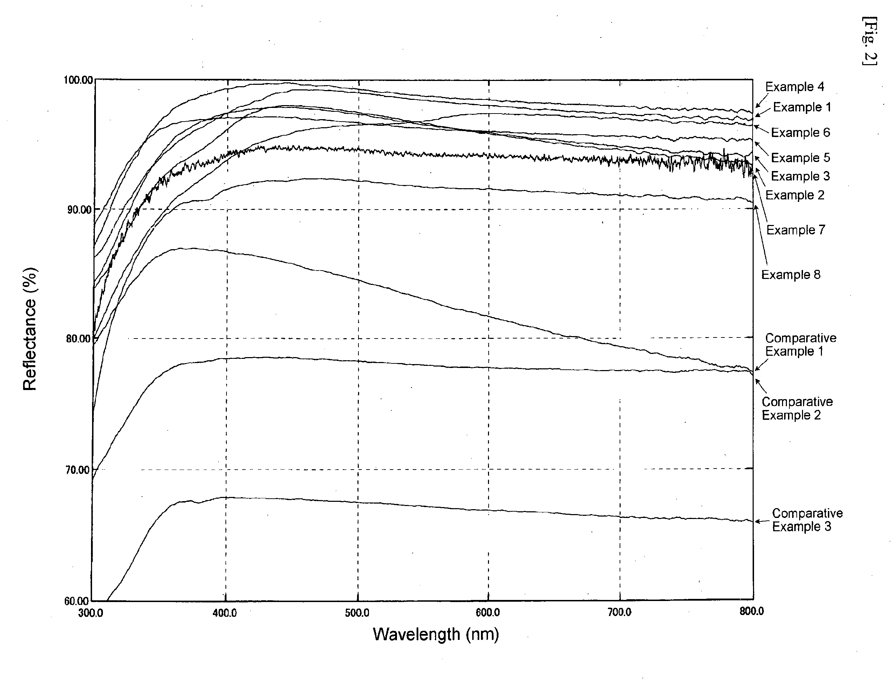

The test results are shown in Tables 1 and 2 and Figs. 1 and 2.

**[Table 1]**

| Separate sheet 1 | | | | | | | | | | | | | | | | | | |
|---|---|---|---|---|---|---|---|---|---|---|---|---|---|---|---|---|---|---|
| Composition | | Example | | | | | | | | | | | | | | | | |
| Part by weight | | 1 | 2 | 3 | 4 | 5 | 6 | 7 | 8 | 9 | 10 | 11 | 12 | 13 | 14 | 15 | 16 | 17 |
| A | A1-1 | 25.8 | 25.8 | 25.8 | 25.8 | 25.8 | 25.8 | 25.8 | 25.8 | 25.8 | | | | 25.8 | 25.8 | 25.8 | 25.8 | 25.8 |
| | A1-2 | | | | | | | | | | 25.8 | | | | | | | |
| | A1-3 | | | | | | | | | | | 43.0 | | | | | | |
| | A1-4 | | | | | | | | | | | | 25.8 | | | | | |
| | A2-1 | 17.2 | 17.2 | 17.2 | 17.2 | 17.2 | 17.2 | 17.2 | 17.2 | 17.2 | 17.2 | | 17.2 | 17.2 | 17.2 | 17.2 | 17.2 | 17.2 |
| B | B-1 | 5.45 | 5.45 | 5.45 | 5.45 | 5.45 | 5.45 | 5.45 | 5.45 | | 5.45 | 1.0 | 5.45 | 5.45 | 5.45 | | 5.45 | 5.45 |
| | B-2 | | | | | | | | | 2.72 | | | | | | | | |
| | B-3 | | | | | | | | | | | | | | | 4.52 | | |
| C | C-1 | 7.0 | 7.0 | 7.0 | 7.0 | 7.0 | 7.0 | 7.0 | 7.0 | 7.0 | 7.0 | 7.0 | 7.0 | 7.0 | | 7.0 | | |
| | C-2 | | | | | | | | | | | | | | 7.0 | | | |
| | C-3 | | | | | | | | | | | | | | | | 7.0 | |
| | C-4 | | | | | | | | | | | | | | | | | 7.0 |
| E | E-1 | 0.027 | 0.027 | 0.027 | 0.027 | 0.027 | 0.027 | 0.027 | 0.027 | | 0.027 | 0.027 | 0.027 | 0.027 | 0.027 | 0.027 | 0.027 | 0.027 |
| | E-2 | | | | | | | | | 0.057 | | | | | | | | |
| F | F-1 | 0.108 | 0.108 | 0.108 | 0.108 | 0.108 | 0.108 | 0.108 | 0.108 | 0.108 | 0.108 | 0.108 | 0.108 | 0.108 | 0.108 | 0.108 | 0.108 | 0.108 |
| G | G-1 | 0.45 | 0.45 | 0.45 | 0.45 | 0.45 | 0.45 | 0.45 | 0.45 | 0.45 | 0.45 | 0.45 | 0.45 | 0.45 | 0.45 | 0.45 | 0.45 | 0.45 |
| | G-2 | 0.80 | 0.80 | 0.80 | 0.80 | 0.80 | 0.80 | 0.80 | 0.80 | 0.80 | 0.80 | 0.80 | 0.80 | 0.80 | 0.80 | 0.80 | 0.80 | 0.80 |
| | G-3 | 0.40 | 0.40 | 0.40 | 0.40 | 0.40 | 0.40 | 0.40 | 0.40 | 0.40 | 0.40 | 0.40 | 0.40 | 0.40 | 0.40 | 0.40 | 0.40 | 0.40 |
| D | D-1 | 150 | 150 | 50 | | | | | | 150 | 30 | 150 | 150 | | 150 | 150 | 150 | 150 |
| | D-2 | | | | 150 | | | | | | | | | | | | | |
| | D-3 | | | | | 150 | | | | | | 350 | | | | | | |
| | D-4 | | | | | | | | | | | | | | | | | |
| | D-5 | | | | | | 100 | | | | | | | | | | | |
| | D-6 | | | | | | | 150 | | | | | | | | | | |
| | D-7 | | | | | | | | 150 | | | | | | | | | |
| | D-13 | | | | | | | | | | | | | 150 | | | | |
| | D-8 | | | | | | | | | | | | | | | | | |
| | D-9 | | | | | | | | | | | | | | | | | |
| | D-10 | | | | | | | | | | | | | | | | | |
| | D-11 | | | | | | | | | | | | | | | | | |
| | D-12 | | | | | | | | | | | | | | | | | |
| Appearance | | White | White | White | White | White | White | White | White | White | White | White | White | White | White | White | White | White |
| Thickness of test piece (µm) | | 500 | 250 | 500 | 500 | 500 | 500 | 500 | 500 | 500 | 500 | 500 | 500 | 500 | 500 | 500 | 500 | 500 |
| Reflectance (%) | | | | | | | | | | | | | | | | | | |
| Wavelength (nm) | 350 | 94 | 92 | 94 | 97 | 96 | 89 | 93 | 89 | 93 | 92 | 93 | 95 | 88 | 93 | 94 | 95 | 93 |
| | 400 | 97 | 96 | 97 | 99 | 97 | 93 | 95 | 91 | 96 | 94 | 95 | 98 | 90 | 97 | 96 | 97 | 96 |
| | 600 | 98 | 96 | 96 | 99 | 96 | 97 | 94 | 91 | 97 | 91 | 96 | 97 | 92 | 98 | 97 | 97 | 97 |
| | 800 | 97 | 93 | 94 | 97 | 95 | 97 | 93 | 90 | 95 | 89 | 94 | 94 | 90 | 96 | 96 | 95 | 96 |

**[Table 2]**

| Separate sheet 2 | | | | | | | | | |
|---|---|---|---|---|---|---|---|---|---|
| Composition | | Comparative Example | | | | | | | |
| Part by weight | | 1 | 2 | 3 | 4 | 5 | 6 | 7 | 8 |
| A | A1-1 | 25.8 | 25.8 | 25.8 | 25.8 | 25.8 | 25.8 | 25.8 | 25.8 |
| | A1-2 | | | | | | | | |
| | A1-3 | | | | | | | | |
| | A1-4 | | | | | | | | |
| | A2-1 | 17.2 | 17.2 | 17.2 | 17.2 | 17.2 | 17.2 | 17.2 | 17.2 |
| B | B-1 | 5.45 | 5.45 | 5.45 | 5.45 | 5.45 | 5.45 | 5.45 | 5.45 |
| | B-2 | | | | | | | | |
| | B-3 | | | | | | | | |
| C | C-1 | 7.0 | 7.0 | 7.0 | 7.0 | 7.0 | 7.0 | 7.0 | 7.0 |
| | C-2 | | | | | | | | |
| | C-3 | | | | | | | | |
| | C-4 | | | | | | | | |
| E | E-1 | 0.027 | 0.027 | 0.027 | 0.027 | 0.027 | 0.027 | 0.027 | 0.027 |
| | E-2 | | | | | | | | |
| F | F-1 | 0.108 | 0.108 | 0.108 | 0.108 | 0.108 | 0.108 | 0.108 | 0.108 |
| G | G-1 | 0.45 | 0.45 | 0.45 | 0.45 | 0.45 | 0.45 | 0.45 | 0.45 |
| | G-2 | 0.80 | 0.80 | 0.80 | 0.80 | 0.80 | 0.80 | 0.80 | 0.80 |
| | G-3 | 0.40 | 0.40 | 0.40 | 0.40 | 0.40 | 0.40 | 0.40 | 0.40 |
| D | D-1 | 16.7 | | | | | | | |
| | D-2 | | | | | | | | |
| | D-3 | | | | | | | | |
| | D-4 | | 150 | 150 | | | | | |
| | D-5 | | | | | | | | |
| | D-6 | | | | | | | | |
| | D-7 | | | | | | | | |
| | D-13 | | | | | | | | |
| | D-8 | | | | 40 | | | | |
| | D-9 | | | | | 100 | | | |
| | D-10 | | | | | | 150 | | |
| | D-11 | | | | | | | 100 | |
| | D-12 | | | | | | | | 100 |
| Appearance | | White | White | White | White | White | White | White | White |
| Thickness of test piece (µm) | | 500 | 500 | 250 | 500 | 500 | 500 | 500 | 500 |
| Reflectance (%) | | | | | | | | | |
| Wavelength (nm) | 350 | 86 | 77 | 66 | 8 | 4 | 5 | 75 | 68 |
| | 400 | 87 | 78 | 68 | 94 | 84 | 73 | 81 | 70 |
| | 600 | 81 | 78 | 67 | 99 | 99 | 93 | 83 | 70 |
| | 800 | 77 | 77 | 66 | 99 | 99 | 97 | 81 | 67 |

**[Table 3]**

| | | Example | | | Comparative Example |
|---|---|---|---|---|---|
| | | 1 | 4 | 5 | 2 |
| Hardness | Type D | 50 | 48 | 45 | 44 |
| Tensile shear adhesion strength | MPa | 2.0 | 1.8 | 1.8 | 1.7 |
| Cohesive failure rate | % | Cohesive failure 100% | Cohesive failure 100% | Cohesive failure 100% | Cohesive failure 100% |

Tables 1 and 2 and Figs. 1 and 2 reveal that reflectance at each wavelength varies depending on the type of the white pigment, and the amount, the average particle diameter and the shape of alumina. For example, with alumina having an average particle diameter of 18 µm, quartz (silicon dioxide) and calcium carbonate, no absorption of light in the near-ultraviolet region was observed, whereas reflectance was generally low in the wavelength region of 300 to 800 nm. It was also revealed that titanium oxide and zinc oxide, which have a high shielding rate, exhibit high reflectance for light in the visible light region, but absorb and fail to reflect most of light in the near-ultraviolet region. In contrast, Examples, in which a certain amount or more of alumina having an average particle diameter of 5 µm or less was dispersed, retained reflectance of 85% or more in the region of 350 to 400 nm. It was also found that round or spherical alumina particles tend to have higher reflectance than amorphous ones.

### INDUSTRIAL APPLICABILITY

The curable polyorganosiloxane composition of the present invention can give, when cured, a cured product that exhibits good reflectivity for light over a wide wavelength region, particularly the violet and/or ultraviolet region, and especially the near-ultraviolet region (350 to 400 nm). Such a cured product is useful as a reflective material. The composition of the present invention also has superior adhesiveness, and is useful as an adhesive for optical elements.

## Claims

1. A curable polyorganosiloxane composition, comprising:
(A) an alkenyl group-containing polyorganosiloxane having at least two alkenyl groups, each bonded to a silicon atom, per molecule;
(B) a polyorganohydrogensiloxane having more than two hydrogen atoms, each bonded to a silicon atom, per molecule;
(C) a polyorganosiloxane represented by formula (II):
Wₜ-Yₛ-SiR⁴ᵣ(OR⁴)₃₋ᵣ (II)
wherein:
W is independently a polyorganosiloxane group represented by the following general formula (II'): 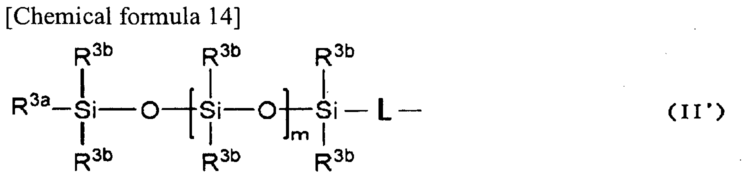 wherein:
R^{3a} is a C₂-C₆ alkenyl group or a C₁-C₆ alkyl group,
R^{3b} is independently a C₁-C₆ alkyl group,
L is a C₂-C₆ alkylene chain, and
m is a number from 5 to 400,
Y is an organosilicon group having a side chain bonded to a silicon atom and represented by the following general formula (III): 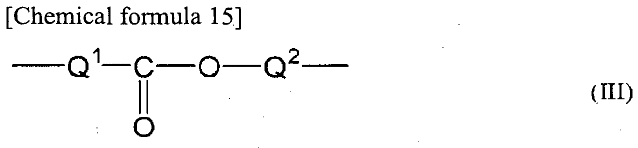 wherein:
Q¹ represents a linear or branched alkylene group that forms a carbon chain having two or more carbon atoms between the silicon atom and an ester bond, and
Q² represents a linear or branched alkylene group that forms a carbon chain having three or more carbon atoms between an oxygen atom and
a silicon atom in a side chain: SiR⁴ᵣ(OR⁴)₃₋ᵣ,
R⁴ independently represents an unsubstituted or substituted alkyl group with 1 to 6 carbon atoms,
t is 1, 2 or 3, and s is 0 or 1; provided that if s is 0, t is 1, and W is bonded to the silicon atom in the side chain: SiR⁴ᵣ(OR⁴)₃₋ᵣ, and if s is 1, t is 1, 2 or 3, and
W is independently bonded to the silicon atom in Y, and
r is 0 or 1;
(D) alumina having an average particle diameter of 5 µm or less; and
(E) a platinum-group metal compound,
wherein Component (D) is 50 to 1000 parts by weight based on a total of 100 parts by weight of Components (A), (B) and (C).

2. The curable polyorganosiloxane composition according to claim 1, wherein, in (C), R^{3a} is a C₂-C₆alkenyl group selected from the group consisting of vinyl, allyl, 3-butenyl and 5-hexenyl; and R^{3b} is a C₁-C₆alkyl group independently selected from the group consisting of methyl, ethyl and propyl.

3. The curable polyorganosiloxane composition according to claim 1 or 2, wherein, in (C), R^{3a} is vinyl, and R³⁶ is methyl.

4. The curable polyorganosiloxane composition according to any one of claims 1 to 3, wherein, in (C), s is 1; Y is an organosiloxane oligomer residue with 2 to 50 silicon atoms, having the side chain bonded to the silicon atom and represented by the formula (III); Q¹ represents ethylene, trimethylene, 2-methylethylene or tetramethylene; and Q² represents trimethylene, 2-methyltrimethylene or tetramethylene; R⁴ independently represents methyl, ethyl, propyl, isopropyl, butyl or 2-methoxyethyl.

5. The curable polyorganosiloxane composition according to any one of claims 1 to 4, wherein, in (C), s is 1; Y is an organosiloxane oligomer residue with 4 to 20 silicon atoms, having the side chain bonded to the silicon atom and represented by the formula (III); Q¹ represents ethylene or 2-methylethylene, Q² represents trimethylene; and R⁴ independently represents methyl or ethyl.

6. The curable polyorganosiloxane composition according to any one of claims 1 to 5, wherein (D) is 75 to 750 parts by weight based on a total of 100 parts by weight of (A), (B) and (C).

7. The curable polyorganosiloxane composition according to any one of claims 1 to 6, wherein the average particle diameter of (D) is 0.1 to 3 µm.

8. The curable polyorganosiloxane composition according to any one of claims 1 to 7, wherein (D) has a spherical shape.

9. An adhesive comprising the curable polyorganosiloxane composition according to any one of claims 1 to 8.

10. A semiconductor·electronic device, in which an optical element is fixed to a substrate using the adhesive according to claim 9.

11. A cured product obtained by curing the curable polyorganosiloxane composition according to any one of claims 1 to 8.

12. The cured product according to claim 11, which is a reflective material.

13. A semiconductor·electronic device, comprising the reflective material according to claim 12.
